# EUROPEAN PATENT APPLICATION

(11) **EP 4 625 385 A1**
(43) Date of publication of application: **01.10.2025**
(21) Application number: 24167753.3
(22) Date of filing: 28.03.2024
(51) Int. Cl.: G08G 1/01, G06F 30/20

(54) **METHOD AND APPARATUS FOR TRAFFIC SIMULATION**

(71) Applicant: FUJITSU LIMITED, Kawasaki-shi, Kanagawa 211-8588 (JP)
(72) Inventor: van den BERGHE, Sven, Slough, SL1 2BE (GB)
(74) Representative: Haseltine Lake Kempner LLP

(57) **Abstract**

A computer-implemented method for traffic simulation, the method comprising: accepting input of traffic data; modelling the effects of an action in a traffic simulation at a plurality of possible time points, by: executing a traffic simulation, using the traffic data, from an initial time point up to a first possible time point to obtain a first preliminary simulated segment state; modifying the first preliminary simulated segment state with the action and executing the traffic simulation beyond a second possible time point to obtain an action simulated state for the first possible time point; executing the traffic simulation from the first possible time point up to a second possible time point, using the first preliminary simulated segment state as an initial state, to obtain a second preliminary simulated segment state; modifying the second preliminary simulated segment state with the action and executing the traffic simulation beyond the second possible time point to obtain an action simulated state for the second possible time point; and comparing the simulated states.

## Description

### Field of the Invention

The present invention relates to traffic simulations. More particularly, the present invention relates to a method for predicting the evolution of traffic simulations and related data processing apparatuses, computer programs, and computer-readable storage media.

### Background of the Invention

There exists a trend where the real world may be represented as a digital world. Recent technology developments have led to the concepts of digital twins (DTs) and "smart cities" - optimising the functioning of social systems for the benefit of their participants by linking virtual representations to real-time sensed data. These concepts have received particular attention, at least in part due to the new and improved technologies that enable advancements within these concepts, such as technologies related to Internet of Things (IoT), 5th Generation technology standard for telecommunications (5G), Artificial Intelligence (Al), and quantum computing, among others. Optimising a smart city's functioning requires developing procedures with which to change the behaviour of the system so as to create the desired simulation state (or simply herein, state).

For improvements related to transport, smart traffic systems are used to deliver a wide range of services to varied users at scale and in real time (or at least fast enough for effective action to be taken). It is desirable for systems to deliver a wide range of services, created by complex processing of primarily real-time sensed data acquired from sources in (or serving) a transport network (for example, from roads and from vehicles). The services are often required in "real time", such that immediate action to be taken by the users of the services. There are diverse data sources, generating different types of data at different rates. The services are also diverse and complex, using the data in a wide range of different ways.

As an example, a transport authority for a large city may create a simulation in the form of a system DT of its public transport infrastructure that provides a real-time virtual model of the flow of traffic throughout the city. The virtual model may be driven by data generated from a wide variety of sources in real time, including: vehicle movements from in-vehicle GPS, roadside sensors, CCTV analysis, routing requests, live dispatches of public transport, etc.; the state and operation of infrastructure, such as traffic lights; and movements of people, from mobile GPS, ticketing activity, CCTV, etc.

Behaviours of agents within a simulation may be changed by acting on the system. There may be a number of possible different actions, with different underlying values and which may possibly be enacted at different times in simulation procedures. One of the functions of a smart city DT is to aid in the selection of the best or most appropriate actions (or even sequences of actions) from a range of possible choices and timings through the prediction of the actions' impacts.

A common technique for predicting impacts of actions is to simulate the future evolution of the system by numerically computing equations describing the time-dependent behaviour and interactions of the actors in the system. Sensed data in this case may be used to specify an initial state, from which the computation or simulation evolves.

While simulation of systems is a well-established technique, DTs have useful features that enable new methods to deliver timely results. One may optimise chosen actions, for example, by exploring a parameter space. For instance, the effect of varying combinations of actions and parameters thereof may be explored by executing many different simulations with different values for the actions and their timings.

Smart city and DT simulations are costly, however, in terms of compute resources used. There are a large number of values used to represent the state of the system, which need to be computed and stored to move forward in time. High speed of results is required to implement actions at the right time so as to change the simulated environment's state; this typically requires high-speed, expensive resources.

As an example, consider the simulation and management of traffic in a city to reduce NOₓ and CO₂ emissions by preventing periods of traffic congestion. Information about the state of the traffic in the city will come from a variety of sources including roadside sensors, mobile phone tracking, and cameras. A DT of the road network, vehicles, and pedestrians may be created to manage the traffic. Levers to control the movement of traffic include the traffic lights (changing phasing to favour certain routes) and speed restrictions. A module of the DT may be configured to predict potential time and duration of congestion. Operators of the DT may use another module to develop the best response to mitigate this congestion. The response module contains a mathematical model of the traffic, say a microscopic, agent-based, model. The operators may use their prior knowledge to rephase particular traffic lights to favour a main highway or thoroughfare but wish to determine the optimal start point and length of time to implement this rephasing. To do this, the operators may initiate simulations, testing the impact of starting the rephasing in 15, 30, 45 and 60 minutes, each costing N (in terms of either compute cost of actual, financial cost associated with the compute costs). Using the state of the art, four full simulations are required, costing 4N.

The inventors have therefore come to the realisation that techniques are required that provide improvements - particularly in terms of compute and financial cost reduction - in realistic simulations of scenarios in digital representations of the real world.

### Summary of the Invention

The invention is defined in the independent claims, to which reference should now be made. Further features are set out in the dependent claims.

According to an aspect of the invention, there is provided a computer-implemented method for traffic simulation. The method includes a step of accepting input of traffic data. The traffic data may be obtained from sensors in and around a geographic region, which is the subject of the traffic simulation.

The method includes a step of modelling the effects on the resultant simulated state(s) of the traffic of an action in the traffic simulation. This effect of the action is assessed at a plurality of possible time points (that is, the time point within the simulation domain where it is possible to implement or execute the action).

Modelling the effects of the action includes executing the traffic simulation using the traffic data from an initial time point up to a first possible time point (from amongst the plurality of possible time points). In this way, the method produces a first preliminary simulated segment state. In this context, the traffic simulation may be decomposed into a series of successive traffic simulation segments, beginning at some initial time. "Preliminary" in this respect indicates that this is prior to application of any action.

Modelling the effect of the action then includes modifying the first preliminary simulated segment state with the action. That is, underlying parameters of the action may be introduced or implemented within the first preliminary simulated segment state (for instance, corresponding underlying parameters, such as traffic light switching phase, may be modified to conform to those of the action). The method then proceeds to execute the traffic simulation, using the modified first preliminary simulated segment state, beyond a second possible time point (from amongst the plurality of possible time points). In this way, the method produces an action simulated state for the first possible time point - i.e., the state of the simulated system in which the action has been applied at the first possible time point.

Modelling the effect of the action also includes executing the traffic simulation from the first possible time point up to a second possible time point. This process uses the first preliminary simulated segment state as an initial state or starting point of this particular simulation segment. That is, in effect, the simulation proceeds up to the second possible time point, without application of the action. In this way, the method produces a second preliminary simulated segment state.

Modelling the effect of the action then includes modifying the second preliminary simulated segment state with the action. The method then proceeds to execute the traffic simulation beyond the second possible time point. In this way, the method produces an action simulated state for the second possible time point.

Modelling the effect of the action then includes performance of a comparison of the simulated states, including a comparison between the action simulated state for the first possible time point and the action simulated state for the second possible time point.

The current state of the art for execution of multiple simulations of the same system with actions occurring at varying times requires a simulation for each instance to be tested to be executed independently in full. This leads to inefficient use of resources since there are periods of the simulation where the same computations are being performed multiple times. For example, in the period between the start of a simulation and the first execution of any action, all simulations will have the same state and each of the independent simulations will be performing identical computations.

The techniques herein make improve efficiency by reducing the total amount of resources consumed in performing the multiple simulations. Rather than execute a number of independent simulations all the way from start to completion, techniques herein stagger execution of simulation segments to when the state of a simulation changes through the application of an action (the first possible time point). At this point, the single execution bifurcates (or splits or forks) into multiple simulation pathways, doubling the resources consumed - but only from the point at which an action is applied. In effect, one of the simulation paths simulates the impact of performing the action, the other of not performing the action.

This model of execution for multiple action timings leads to the simulation being split into a number of simulation segments bounded by the application (or not) of an action. Segments that start with the same sequence of action applications start with the same state and so their execution may be shared between multiple simulation pathways. In this way, the techniques herein allow for a greater uptake of smart city DTs by minimising the resources required to investigate the effects of actions in smart city simulations.

In effect, the techniques herein split the simulation execution process into segments bordered by the application of actions. Where multiple simulated systems have or are expected to have the same state, techniques herein are able to execute just a single thread (a single simulation segment) and share resultant data amongst distinct simulation branches. In this way, it is possible to use saved state to eliminate unnecessary re-executions of simulated segments. By handling simulation segments, resources may be allocated adaptively.

Optionally, the effect of the action on traffic may be considered as part of the comparison of simulated states. For instance, the state may be quantified in respect of any or all of the following: a number of vehicles inside the simulated region; numbers of each of a plurality of transport modalities inside the simulated region; locations of vehicles inside the simulated region; directions of travel of vehicles inside the simulated region; speeds of vehicles inside the simulated region; average speeds of vehicles inside the simulated region; minimum and/or maximum speeds of vehicles inside the simulated region; a level of congestion inside the simulated region; a number of traffic jams inside the simulated region; a level of use of a road network inside the simulated region; a maximum transit capacity inside the simulated region; and a level of emission output inside the simulated region.

The simulations (e.g., DTs) may be configured as a microscopic model, a mesoscopic model, a macroscopic model, or any other model granularity. As an example, a microscopic model describes vehicles and pedestrian behaviour with high detail and individually on the traffic stream. A mesoscopic model may not distinguish or trace individual vehicles or pedestrians, but may express the probability of having a given vehicle or pedestrian at a given position, time and velocity. A macroscopic model may represent traffic at a high level of aggregation without distinguishing vehicles or pedestrians individually.

The action here may be reflective of an intervention into the simulated system, and may include a constraint on any or all of the following: a number of vehicles inside the simulated region; transport modality inside the simulated region; locations of vehicles inside the simulated region; directions of travel of vehicles inside the simulated region; speeds of vehicles inside the simulated region; a number of accessible lanes and/or roads; a number of accessible stops and/or stations; and traffic light behaviour.

Any system that is capable of acquiring (or processing acquired) sensor data and modelling the effect of an action in a simulation is suitable for administering the above method. The reader is directed to European Patent Application No. 23382595.9 and European Patent Application No. 23382594.2 for two representative examples of suitable systems.

The skilled reader will appreciate the applicability of the techniques herein to such fields as traffic planning and engineering, where the techniques may be used for evaluating the impact of road infrastructure changes, traffic management strategies, and public transportation services. In the field of autonomous vehicle development, testing and evaluating the behaviour of self-driving cars in simulated environments may be provided by techniques herein. In the field of urban planning, the techniques herein allow for studying the impact of transportation systems on land use, air quality, and energy consumption.

Beyond transport networks, the techniques herein may be extended to model other systems of mass facilitation. This versatility makes the approach a valuable asset for diverse industries and sectors seeking to simulate and optimise various complex systems. For example, the techniques are equally applicable to commercial transportation and the transit of goods.

The techniques herein are suitable for any simulation implementations in which there is a time component and actions by which to change or modify the simulation state. One further example is in the management of "Smart Grids", where balancing power load thereby ensuring that highly variable power generated by renewables is used by varying pricing according to anticipated supply and demand. If there is an increase in demand from, say, wind generation due to strong winds, then it is desirable to ensure that the energy gets used. However, as most demand may be geographically elsewhere, the effect on the transmission network is desirably also managed to ensure that the network is not overloaded. Variable pricing may be used as a mechanism to manage demand and if this is applied regionally, one may manage the transmission network load. Simulation may be used to develop the best (or generally optimum) plan over time in response to variations in production and demand over time and space in response to pricing changes. The "actions" in this example may be when, how significantly, and where to change the price. In addition, the production profile may also be uncertain, so external "actions" may include different production profiles, e.g. timing and length of peak wind.

A further example use case is in the simulation of climate, so as to design and evaluate policies to reduce CO2 emissions where policies may be implemented at different times or phased in in different ways. The "core" simulation may simulate the evolution of the earth's climate over time with a social component that models any response to polices and any resulting change in CO2 emissions. "Actions", in this context, may include the policies.

One further example use case concerns the extraction of oil and/or gas from underground reservoirs with the aim to maximise total oil and/or gas production, which is affected by the location of wells, by the rate of extraction, and by the location and rate of injection of fluids to displace the hydrocarbons towards extraction wells. Simulation over time may be used to optimise the production/injection profiles. "Actions", in this context, may include well locations, timings and rates.

Thus, "traffic" in this context refers to the flux of data representative of entities (vehicles, pedestrians, commodities, resources, etc.).

Execution of traffic simulations may be performed using current state of the art simulators. For instance, simulations are typically built around discretized ordinary differential equation (ODE) solvers, for example Simulation of Urban MObility (SUMO) (Krajzewicz et al. 2012), to update the vehicle's (or traffic participant's) speed and position. SUMO may be used to execute simulations and/or simulation segments. Of course, other traffic simulation models and solvers are equally appropriate, including AIMSUN (Casas et al. 2010), MATsim (W Axhausen et al. 2016), ARCHISIM (Champion et al. 2001), and VISSIM (Fellendorf et al. 2010).

Optionally, the method may include modelling the effects of a plurality of actions in the traffic simulation. This may be performed by repeating the above-described steps, executing the traffic simulation and subsequently modifying preliminary simulated segment states with actions from amongst the plurality of actions. The modelling may additionally or alternatively include modelling the effects of the action (or actions) at a plurality of corresponding possible time points. For instance, a single action may be modelled at three distinct possible time points. Or, for two actions, a first action may be modelled at two possible time points and a second action may be modelled at two possible time points. In this way, for example, a sequence of actions may be analysed; the method may determine which execution pathways operate on identical data and take the appropriate action to ensure that these simulated segments present within multiple pathways are not unnecessarily re-processed.

One manner in which the effects of a plurality of actions in the traffic simulation may be modelled includes a step of modifying the action (or parameter thereof) to obtain a modified action (or equivalently, a second action). Modelling the effects of the actions then includes modifying the first preliminary simulated segment state with the modified action. The method then proceeds to execute the traffic simulation (using the first preliminary simulated segment state modified with the modified action) beyond the second possible time point to obtain a modified action simulated state for the first possible time point. Similarly, modelling the effects of the action then includes modifying the second preliminary simulated segment state with the modified action and executing the traffic simulation beyond the second possible time point to obtain a modified action simulated state for the second possible time point. The comparison of simulated states may then include comparing the simulated states, including the action simulated state for the first possible time point, the modified action simulated state for the first possible time point, the action simulated state for the second possible time point, and the modified action simulated state for the second possible time point.

Optionally, the method may further comprise a step of performing an optimisation search amongst the plurality of actions (or amongst action simulated states for each of the plurality of actions) with respect to action parameters. That is, simulations may be iterated over action parameters (e.g., different phases for an action related to change of phase of a traffic light) so as to converge to the "best" choice for that particular action. In this way, the optimisation search may identify a selected (or "optimum") action (and the associated selected action simulated state). Selected action simulated states may be reused over subsequent simulation iterations, where preceding action sequences are the same. The skilled reader will appreciate that a variety of optimisation techniques may be implemented for this purpose, so long as the optimisation technique is capable of repeating evaluations (simulations) with different action timings or underlying parameter values. Suitable techniques include convergent iterative methods.

Optionally, the method may include an aspect of pruning unnecessary or superfluous simulation branches. One manner by which pruning may be achieved is, in the step of comparing the simulated states, determining a similarity metric between simulated state. When the similarity metric is above a threshold (or, of course, below a metric if the metric formulated in such a manner that a low value indicates high similarity), the method may delete one of the action simulated states (e.g., the action simulated state for the first possible time point or the action simulated state for the second possible time point) and associated data. That is, in cases where variation in the point in time at which the action is applied does not have a significant impact on the effect of the action, it is unnecessary to proceed with distinct simulations; a single simulation pathway is sufficient to model the effects of application of the action as both time points.

Optionally, modelling the effects of the action in the traffic simulation may be triggered through reception of an action list. A single action list may comprise all actions to be applied to the traffic simulation and all possible time points at which the actions are to be applied to the traffic simulation. In this way, the implementing computing means may proceed with traffic simulation without further intervention from the operator.

Optionally, modelling the action in the traffic simulation at one of the plurality of possible time points may further comprise saving simulated segment states (for instance, preliminary simulated segment states and/or action simulated segment states) to a state storage module. Executing each traffic simulation (in particular, segments thereof) may be performed by a segment execution module; for instance, a first traffic simulation segment may be executed by a first segment execution module and a second traffic simulation segment may be executed by a second segment execution module. All segment execution modules may have access to the state storage module, such that a segment execution module may readily access simulated states for other segments. This arrangement and compartmentalisation of processing routines allows for efficient read and write of individual simulation segment details and allows for straightforward implementation of the above-described pruning.

Optionally, the segment execution modules and state storage modules (and indeed other relevant modules) may be - at least in part - hosted on one or more remote servers. That is, the modules may be cloud-based. In this manner, it is possible to simply increase processing capabilities by initialising additional compute threads. High-Performance Computing (HPC) clusters may be used in this respect. Of course, a combination of local processing units and remote processing units may be utilised.

Optionally, modelling the effects of the action in the traffic simulation may further comprise scheduling the execution of any traffic simulation (and scheduling the modification of preliminary simulated segment states with action) using a resource manager module. Such a module may be communicatively coupled with all segment execution modules and the state storage module, so as to provide a single administrative function. Again, this allows for efficient read and write of individual simulation segment details.

Optionally, the traffic data may be acquired in real-time from sensors. Optionally, the sensors may be any or all of the following: GPS sensors or antennas; cellular network sensors or antennas; loop sensors or loop detectors, which may register the number of passing vehicles; camera sensors; and vehicle parking sensors. The sensors may be on-board sensors, for example a GPS sensor or cellular (telecommunications) sensor provided within or on a vehicle or pedestrian, configured to transmit the position of the vehicle or pedestrian. Antenna signal triangulation may be used to determine traffic position. Alongside GPS data and cellular data, any other floating car data may be suitably used. Camera sensors may be used to remotely accumulate image data, upon which image processing techniques such as object detection may be used to provide vehicle or pedestrian positioning data. Vehicle parking sensors (either on-board or remote to the vehicle) may be used to indicate the parked position of vehicles, thereby providing, for example, parking facility occupation level.

For example, the traffic data may include any of vehicle counts, types of vehicles, speed, average speed, maximum speed, minimum speed, level of congestion, traffic jams (number of), the level of use of the road network, maximum transit capacity, weather conditions, presence of a prearranged event (such as a concert, sporting event). Each of the data may be provided as a time series.

Optionally, the method may include a step of accepting input (into the implementing computing means) of historical traffic data for the simulated region or the geographic region. The method may then include a step of executing the traffic simulation, making use of both the traffic data and any historical traffic data. For instance, the simulation may make use historical of vehicular or pedestrian for a given geographic region alongside live data.

Optionally, the traffic data may comprise data obtained from a DT of the geographic region. That is, the simulation corresponds to a real-world geographic region, with real-world underlying components including, for example, road segments and real-time sensed traffic participants (vehicles and pedestrians). That is, any sensors may be configured to output sensor data to a DT. A DT in this context is a digital model of the traffic system that serves as the effectively indistinguishable digital counterpart of the traffic system for such purposes as simulation, integration, testing, monitoring, and maintenance of the real-life system.

The techniques herein may exploit the unique features of DT simulations to reduce the resources used to find optimal actions to apply leading to more cost-effective smart city DTs. Vehicular traffic and human traffic behavioural models play an important role in the field of DTs and will benefit future, for instance, metaverse solutions. The techniques herein provide realistic future simulations that are predictive and adaptive to account for abnormal or unexpected future scenarios.

The techniques herein may be applied to agent-based modelling systems (ABMSs), in which simulation of the actions and interactions of autonomous agents (both individual or collective entities such as organisations or groups) enable understanding of the behaviour of the traffic system. Broadly, agents of an ABMS may have their own preprogrammed goals and the system as a whole may have a preprogrammed goal. Agents may be interconnected with other agents, and each may be implemented as a software module or bot. In a traffic scenario, one agent may be representative of a traffic intersection or an individual vehicle.

In conventional ABMSs used for simulation, the intentions of the modelled behaviours do not evolve with time. Consequently, every time that a behaviour needs to be incorporated into the simulation, a new ABMS model needs to be created, which is not efficient. Techniques herein provide a system able to adapt and evolve current simulation systems, and thereby provide more realistic behaviours. The techniques provide predictive and adaptive simulations for abnormal and forecasted scenarios in DTs, and enable smart decision-making for anticipating potential new behaviours of the simulation given new contexts in DTs.

Optionally, the method may be configured to cause output of data or instructions into the real world. For instance, in the event that an action is deemed to be appropriate for implementation, for instance which demonstrates (via simulation) that a target will be met (e.g., congestion reduction, or emission reduction), the method may cause output of instructions corresponding to the selected action so as to implement the selected action within a real traffic system. This could be, for example, instructions to a user (e.g., a traffic authority) to close a road or apply a contraflow arrangement. The instructions may be output in the form of computer-readable instructions, so as to implement the selected intervention without human intervention (e.g., close an electronically controlled gate or display a revised maximum speed limit on smart motorway signage).

The method provides accurate and realistic simulations, which recreate future behaviours based on potential events (interventions) that affect the real-world behaviour of the underlying system. The method offers and integrates smart decision-making in current scenarios, which enables the application of potential countermeasures so as to minimise the potential impact of upcoming scenarios. In effect, the method enables digital rehearsals with interventions.

The techniques herein offer adaptability, enabling adaptive simulations for potentially abnormal and forecasted upcoming scenarios as quickly as required by the user.

Embodiments of another aspect include a data processing apparatus, which comprises a memory and a processor. The memory stores computer-executable instructions to carry out a computer-implemented method for traffic simulation. The processor is configured to execute the instructions. The data processing apparatus may further include means to accept input.

Embodiments of another aspect include a computer program comprising instructions, which, when executed by computer, causes the compute to execute a computer-implemented method for traffic simulation.

Embodiments of another aspect include a non-transitory computer-readable storage medium comprising instructions, which, when executed by a computer, cause the computer to execute a computer-implemented method for traffic simulation.

The invention may be implemented in digital electronic circuitry, or in computer hardware, firmware, software, or in combinations thereof. The invention may be implemented as a computer program or a computer program product, i.e., a computer program tangibly embodied in a non-transitory information carrier, e.g., in a machine-readable storage device or in a propagated signal, for execution by, or to control the operation of, one or more hardware modules.

A computer program may be in the form of a stand-alone program, a computer program portion, or more than one computer program, and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of the invention may be performed by one or more programmable processors executing a computer program to perform functions of the invention by operating on input data and generating output. Apparatus of the invention may be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions coupled to one or more memory devices for storing instructions and data.

The invention is described in terms of particular embodiments. Other embodiments are within the scope of the following claims. For example, the steps of the invention may be performed in a different order and still achieve desirable results.

Elements of the invention have been described using the terms "processor", "input device" The skilled person will appreciate that such functional terms and their equivalents may refer to parts of the system that are spatially separate but combine to serve the function defined. Equally, the same physical parts of the system may provide two or more of the functions defined. For example, separately defined means may be implemented using the same memory and/or processor as appropriate.

### Brief Description of the Drawings

Reference is made, by way of example only, to the accompanying drawings in which:
FIGURE 1 is a flowchart of a general method for traffic simulation according to embodiments;
FIGURE 2 is an overview of modelling the effects of an action in a traffic simulation at two possible time points according to techniques herein;
FIGURE 3 is an overview of modelling the effects of two actions at four possible time points according to a known technique;
FIGURE 4 is an overview of modelling the effects of two actions at four possible time points according to techniques herein;
FIGURE 5 is a schematic overview of a modular computing architecture suitable for implementing techniques herein;
FIGURE 6 is a flowchart of a method for processing simulation segments;
FIGURE 7 is a flowchart of a method for converting an action plan into an action list;
FIGURE 8 is a flowchart of a method for processing simulation segments using an action list;
FIGURE 9 is an overview of modelling the effects of an action with action list excerpts at 5 example time points;
FIGURE 10 is an overview of modelling the effects of a traffic simulation with pruning of a simulation pathway; and
FIGURE 11 is a block diagram of computational means for implementation of methods according to embodiments.

### Detailed Description

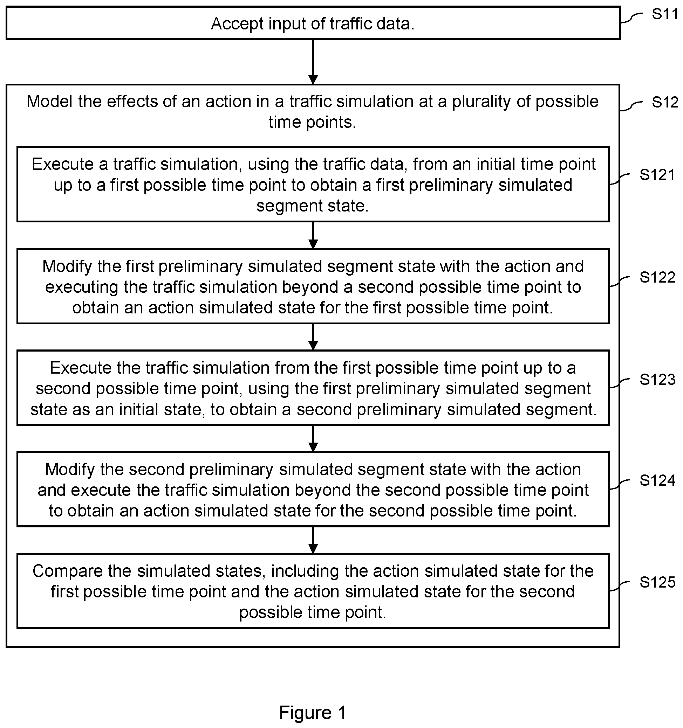

FIGURE 1 is an overview of a general method for a traffic simulation, which addresses the above-described shortcomings of known simulation techniques. At S11, the computing means that is implementing the general method accepts input of traffic data, which comprises - for example - data obtained from sensors in a geographic region. At S12, the computing means models the effects of applying an action on the traffic simulation at various possible time points.

In more detail, S12 includes a first step, S121, of executing the traffic simulation, using the traffic data, from an initial time point up to a first possible time point to obtain a first preliminary simulated segment state. There may be a preliminary step of decomposing the traffic simulation into simulation segments (that is, segments to be simulated so as to produce simulated segment states). Alternatively decomposing the traffic simulation into simulation segments may be an ongoing process or unnecessary as the implementing computing means is configured to advance the simulation by a predetermined time at each simulation increment (thus effectively advancing the simulation by a simulation segment).

At S122, the implementing computing means modifies the first preliminary simulated segment state with the action and executing the traffic simulation beyond a second possible time point to obtain an action simulated state for the first possible time point.

At S123, the implementing computing means executes the traffic simulation from the first possible time point up to a second possible time point, using the first preliminary simulated segment state as an initial state, to obtain a second preliminary simulated segment.

At S124, the implementing computing means modifies the second preliminary simulated segment state with the action and executes the traffic simulation beyond the second possible time point to obtain an action simulated state for the second possible time point.

At S125, the implementing computing means compares the simulated states, including the action simulated state for the first possible time point and the action simulated state for the second possible time point.

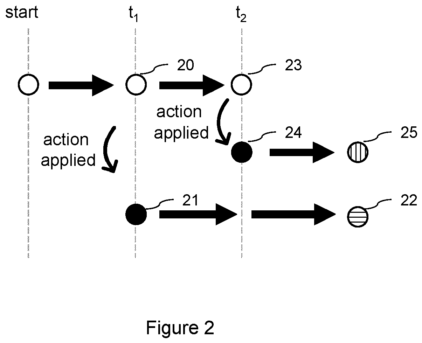

FIGURE 2 is an overview of the technique of modelling the effects of an action in a traffic simulation at two possible time points. The implementing computing means initialises a traffic simulation from an initial time point, which continues until the first time point, t₁, at which application of the action is deemed to be an option (this may be predetermined by the user). At t₁, the state of the simulated system (or at least the first segment thereof) is referred to as the first preliminary simulated segment state 20. The implementing computing means modifies the first preliminary simulated segment state 20 with the action or parameters thereof to obtain a first transient simulated state 21. The simulation continues, beginning with the first transient simulated state 21 at t₁ and proceeding until and beyond t₂. The resultant simulated state is referred to as the action simulated state for the first possible time point 22.

Simultaneously or consecutively, the implementing computing means advances the first preliminary simulated segment state 20 to a second possible time point, t₂. At t₂, the state of this simulated system is referred to as the second preliminary simulated segment state 23. The implementing computing means modifies the second preliminary simulated segment state 23 with the action or parameters thereof to obtain a second transient simulated state 24. The simulation continues, beginning with the second transient simulated state 24 at t₂ and proceeding beyond t₂. The resultant simulated state is referred to as the action simulated state for the second possible time point 25.

Events creating a state change do not have to be actions that are being optimised. Events could also arise from external causes. For example, techniques may be used to optimise the quantification of the sensitivity of an airport's operations to the delayed arrival time of one or more aircraft.

Note also that actions that are applied at various times may also have other parameters that may be varied to optimise their effect, for instance a pricing change to encourage mode shift of transport could be tested at different values. In this case, there will be more than two threads created when an action is applied (say, for each of the tested prices), but the principle remains the same.

Actions may have a duration; action events may be inserted for the start and the end of the duration.

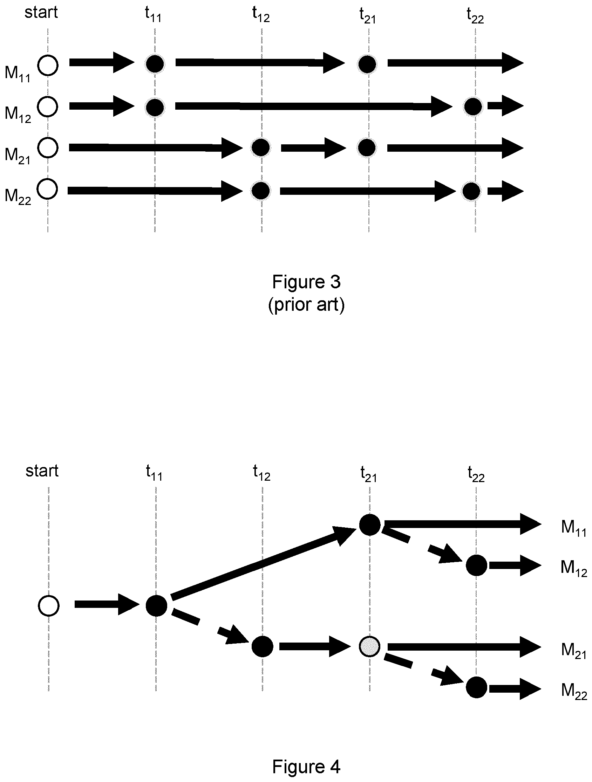

For comparative purposes, FIGURE 3 demonstrates a prior art technique for the execution of a simulation (of simulation segments) of an ensemble simulation (M) (i.e., a collection of simulations with changes to the actions) that is seeking to optimise the implementations of two actions, A₁ and A₂. A₁ may be implemented at two times - t₁₁ or t₁₂. Similarly, A₂ may be implemented at two different times, t₂, or t₂₂.

For simplicity, assume that the wall clock time, T, of simulation is the same for each of the intervals between implementations of actions and so the cost, C, is also equal (i.e., t₁₁ = t₁₂ = t₂₁ = t₂₂). Of course, the skilled reader will appreciate that time steps need not be equal. Cost in this context may refer to computation cost (e.g., flops required to perform the simulation segment) and/or the financial cost of operating the simulations.

In the state-of-the-art implementation, each of the simulations (M₁₁ (action A₁ applied at time t₁₁), M₁₂ (action A₁ at time t₁₂), M₂₁ (action A₂ at time t₂₁), and M₂₂ (action A₂ at time t₂₂)) are executed independently the whole way through. For instance, with simulation M₁₁, action A₁ is applied at time t₁₁ and action A₂ is applied at time t₂₁; with simulation M₂₁, action A₁ is applied at time t₁₂ and action A₂ is applied at time t₂₁. Here, four allocations of compute resources are occupied for the full wall clock execution time. For instance, the total cost for execution up to the implementation of A₂ at t₂, is 4×3×C = 12C (each of the four ensemble simulations Mₓₓ incurs a simulation cost of C for t₀ to t₁₁, C for t₁₁ to t₁₂, and C for t₁₂ to t₂₁).

FIGURE 4 shows how resources are utilised more efficiently using the techniques herein. All four ensemble simulations have the same state at the start (and until t₁ₓ). Only a single execution therefore needs to be executed up to t₁₁ (in the state of the art, as above, this would require simulation of four duplicated simulation segments). This increases to two distinct simulations as one ensemble simulation implements A₁ at t₁₂, and another does not (illustrated with a dashed arrow, continuing from the node at t₁₁). The two simulation branches execute until t₂₁ when the process is repeated and the simulation pathway bifurcates again, with one branch executing A₂ at t₂₁ and the other holding on until t₂₂. After t₂₁, four simulations are executing as in the state-of-the-art execution scheme, as indicated with the use of the Mₓₓ notation on the right-hand side.

The cost of execution of the improved scheme up to the implementation of A₂ at t₂₁ is 1×C + 2×2×C = 5C, a significant saving relative to the state-of-the-art cost. Note that the improved execution scheme has no effect on the wall clock time taken to deliver the simulation results.

This present example considers the same action applied at different times, e.g. A₁ at t₁₁ or t₁₂. As above, it is of course possible to generalise this by applying a sequence of actions, e.g., executing action A₁₁ at t₁₁ or executing A₁₂ at t₁₂ using the same principles as described herein.

Bifurcation may be implemented by requesting the executing thread to export its state to external files (a capability that is part of many simulation programs). Alternatively, as will be described later, in some systems the state may be saved to a local (for instance, disk) - or apparently local (for instance, a cloud-based volume) - store and execution of bifurcation occurs by reading this state in a new thread of execution.

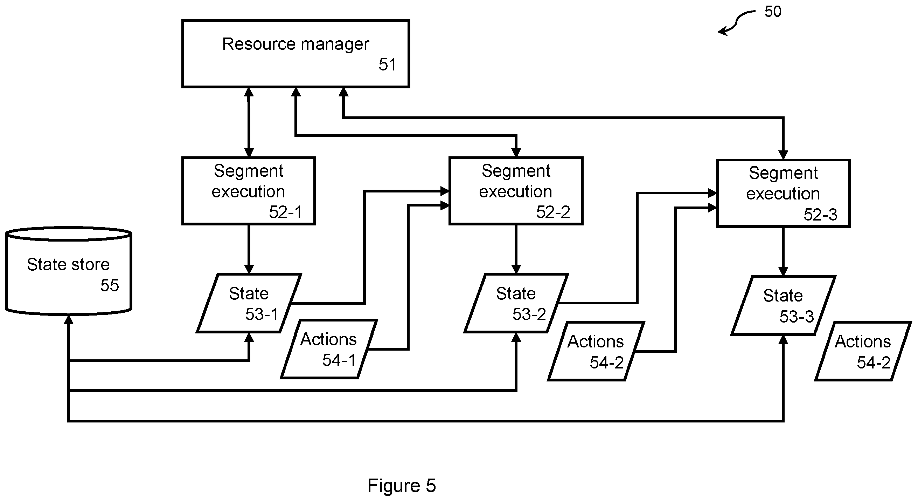

FIGURE 5 demonstrates a modular computing architecture 50, suitable for implementing the techniques herein. Simulation segment execution modules 52-1, 52-2, 52-3 execute simulation with one or more simulation segments. Initial states and actions are read from the output of a previously executed segment. For example simulation segment execution module 52-2, which is simulating a second segment, may read the output of simulation segment execution module 52-1.

A resource manager 51 oversees execution, acquiring resources to execute the simulation as required and initiating segment simulation by segment execution modules 52 when informed or it becomes apparent that the segment's input data are available. For example, resource manager 51 may identify which accessible resources are free or will be free and may use operating system controls to reserve such resources for the simulation. In a cloud-based environment, the resource manager 51 may request the cloud environment to "give" or allocate the simulation new resources (e.g., a virtual machine).

States 53 (e.g., the resultant state of a segment following simulation) are saved to a state store module 55. In this way, states 53 may be accessed by any or all segment execution modules 52, so as to reduce computation time. Similarly, details of actions 54 may be saved to an action store (not depicted), which may be accessed by all other relevant modules are required. The simulator SUMO allows for states to be saved at set times and to be reloaded with ease.

Of course, only three segment execution modules 52 and corresponding states 53 and actions 54 are illustrated: more modules may be utilised as required, though modules may also be reused when available. Modules may be physical components, such as processing cores, or may be virtualised components, such as virtual machines or containerized services. The state store 55 may be or include, for example, NoSQL databases, SQL databases, and time series databases.

The simulator decoder component may incorporate any other additional parameters required for the set-up of the simulation system, such as, the network used for the simulation, agent details, etc.

The exact format and structure of the segment execution modules 52 will vary depending on the simulation system in use. Suitable examples of simulation systems include the proprietary software AnyLogic (developed by The AnyLogic Company), the open-source transportation modelling and simulation toolbox TRANSIMS, the open-source microscopic and continuous multi-modal simulation package Simulation of Urban MObility, SUMO, (developed by the German Aerospace Center), FlameGPU (developed by Richmond, P. *et al,* doi: 10.5281/ZENODO.5428984), and proprietary software Junctions (developed by Transport Research Laboratory). The skilled reader will appreciate that there are many suitable simulation systems, depending on the purpose.

As seen throughout the present example, a data processing apparatus that implements the method for traffic simulation may be configured in terms of functional units or modules. Such units or modules may comprise processing circuitry configured to perform the role of the above-resource manager 51 and segment execution modules 52 and sub-modules and components thereof. System 50 may be configured as an application programming interface (API), enabling communication between at least the real world sensors and the chosen simulation system.

In one example, the modular computing architecture 50 may be implemented using a combination of object-oriented programming languages Python (used, for example, for the initialising and execution simulation segments) and Java (largely for back-end logic, including interfacing with any state store 55 modules).

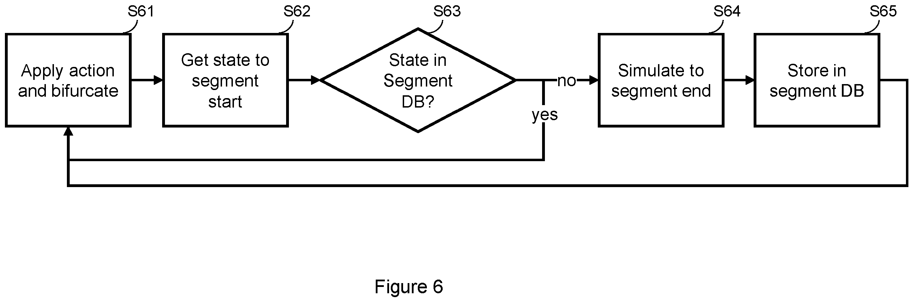

FIGURE 6 shows the control flow for this access procedure using modular computing architecture 50 of implementing computing means. At S61, the implementing computing means initiates or initialises the access procedure when the simulation of a segment on the execution branch has finished and a new action could be applied. At S62, the computing means applies the action and bifurcates the simulations so as to obtain "applied" and "not applied" branches. For each branch, at S63, the computing means queries the state store module 55 for a precomputed state that has seen the application of the same action(s) up to the segment start point, including the last action. If the segment exists in the state store module 55 (S63, "yes"), the access procedure proceeds to the next segment and the access procedure returns to S61. Otherwise (S63, "no"), the implementing computing means simulates the segment at S64, and, at S65, the implementing computing means stores the simulated segment in the state store module 55. The access procedure then returns to S61 and proceeds to the process the next segment.

Before execution of any simulation, an *action list* may be created, using a plan of actions (or *action plan*) input into the system (by a user or received from an external computing entity). The action list includes a list of changes to the system state (equivalently, actions), parameters of the changes, and the simulation time at which the changes are to be applied. An action list may also include a special "null" action that indicates that the state is not to be changed before execution of the simulation (or next simulation segment) begins. If the action plan contains the same action applied at different times - which indicates that a bifurcation may be applied - then the action list contains a null action, indicating continuation without a change of state, before the application of the action.

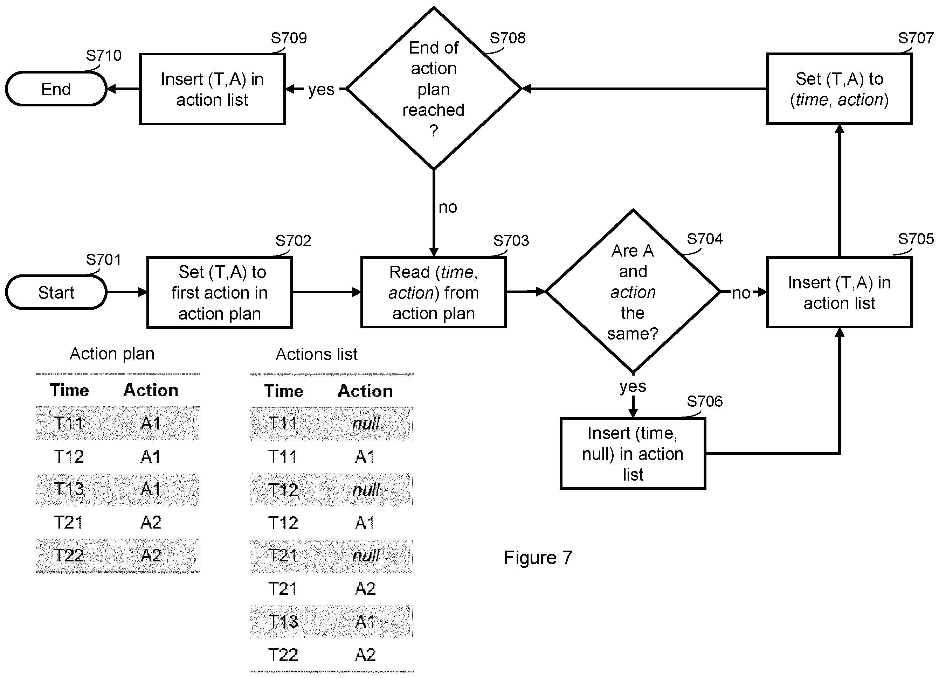

FIGURE 7 illustrates one process suitable for creating an action list. An example action plan is provided in the table on the left-hand side, which lists the actions to be applied to the system under consideration: there are 2 actions (A1 and A2) to be applied at 5 different times (T11, T12, T13, T21, T22). In this example, T13 occurs *after* T21. The entries in the action plan are not necessarily ordered by time (though the same actions are grouped in adjacent lines for ease of reference here).

The *action plan* is read line-by-line and processed by implementing computing means as illustrated, by comparing the current time and current action to the previously read time and action. That is, the implementing computing means begins processing at S701 and sets a temporary first time and action pair (T,A) (the current time and current action) to the first action and time in the action plan at S702 (in effect, an initialisation step). At S703, the implementing computing means reads the time and action variables from the action plan (i.e., the current action). If the value A (i.e., the previous action under consideration) and the action from the action plan (the current action) differ (S704, "no"), then the technique has come to the end of a group of optional actions (i.e., actions that may be implemented at different times and or with different underlying parameters) and the *previously* read action and its corresponding time are inserted into the action list at S705. The insertion operation may produce a sorted list using standard techniques to first order by ascending time and, when times are the same, by inserting null actions before other actions.

Alternatively, if the current and previous actions are the same (S704, "yes"), we are inside a group of optional actions, then a null action is inserted at S706 into the action list followed by the previously read action and time and the technique proceeds to S705. For example, with the first loop following initialisation, the implementing computing means is comparing the first line in the action plan with itself and thus, T11 is inserted into the action list as a first entry along with the null action value.

As S707, the implementing computing means updates the temporary variable (T,A) to be the just-inserted time and action pair and proceeds to S708, where it is determined if the technique has reached the end of the given action plan. In the event that there are further actions to process (S708, "no"), the implementing computing means returns to S703, now using the updated temporary variable (T,A). In the event that all actions and corresponding times have been accounted for (S708, "yes"), the implementing computing means inserts the temporary variable (T,A) into the action list at S709. The action plan/list processing technique concludes at S710.

The resultant *action list* for the given example is provided at the in the table on the left-hand side. The action list may be used by implementing computing means to manage simulations and bifurcations. Once processed, the output actions list may be sorted into ascending time order.

Tabular format action lists (and action plans) may be readily implemented into simulation techniques. One manner of encoding this tabular format includes expressing the action list using JSON encoding. As an example, the following JSON excerpt is an action plan for a traffic management example, in which the action corresponds to the change in the phase of traffic lights and underlying action parameters dictate that the lights are to be rephased or restored to a default value.

```
   [
   {"time": "13.00", "action": {"id":1, "apply": "rephase light set 1"}},
   {"time": "14.00, "action": {"id":1, "apply": "rephase lights set 1"}},
   {"time": "16.00, "action": {"id":1, "apply": "rephase lights set 1"}},
   {"time": "15.00", "action": {"id":2, "apply":" restore lights set 1"}},
   {"time": "17.00", "action": {"id":2, "apply":" restore lights set 1"}}
   ]
```

The intention here is to examine options for the timing and length of rephasing a set of traffic lights to temporarily prioritise traffic flow in one direction, starting the new phasing at one of 3 different times and ending the phasing at 2 other times. In particular: rephrase from 1pm to 3pm; rephrase from 1pm to 5pm; rephrase from 2 pm to 3pm; rephrase from 2 pm to 5pm; and rephrase from 4 pm to 5pm.

Following the processing technique described above and as set out in FIGURE 7, the resultant action list, using JSON encoding, may be as follows:
The resulting Action List, encoded as JSON, could be:

```
   [
   {"time": "13.00", "action": ["id":1}},
   {"time": "13.00", "action": {"id":1, "apply": "rephase light set 1"}},
   {"time": "14.00", "action": ["id":1}},
   {"time": "14.00", "action": {"id":1, "apply": "rephase lights set 1"}},
   {"time": "15.00" "action": {"id":2}},
   {"time": "15.00", "action": {"id":2, "apply": "restore lights set 1"}},
   {"time": "16.00", "action": {"id":1, "apply": "rephase lights set 1"}},
   {"time": "17.00", "action": {"id":2, "apply": "restore lights set 1"}}
   ]
```

Null actions are indicated by the lack of an apply section. Of course, alternative file formats may be used to store or encode attribute-value pairs and arrays, including XML and YAML.

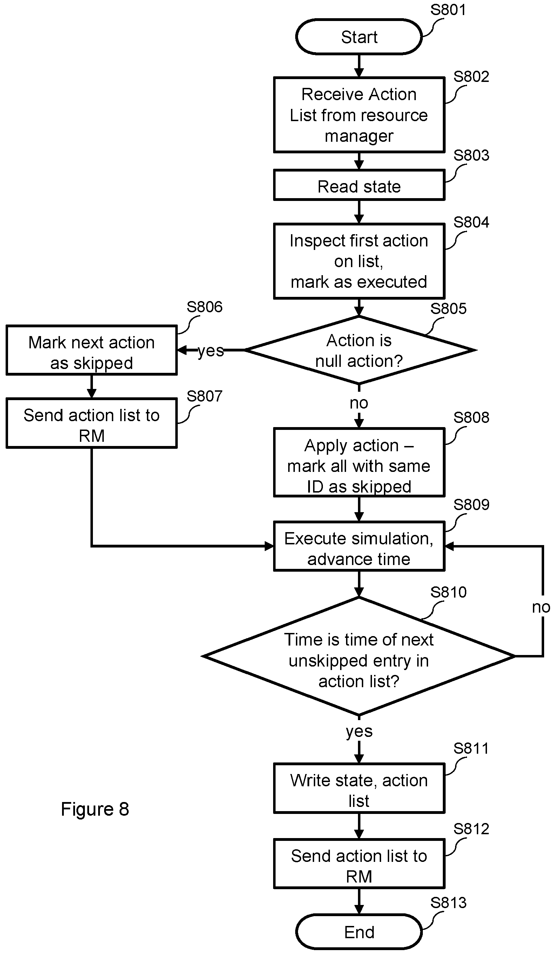

Each simulation segment that is bounded by the possible application of an action may be processed by implementing computation means according to the flow depicted in FIGURE 8. There may be multiple versions of a simulation state for the same simulation time since there may be multiple paths through the actions. This means that saved states are preferably labelled, so as to identify the execution path to which the saved state belongs. Techniques to achieve successful state identification include generating probable unique identifiers (UUlDs) to be attached to the state and informing the action list used to initiate a simulation segment of the correct identifier, using file references, or sequence numbers, for example.

It is also possible for the simulation segment execution modules 52 to identify the correct simulation state using the unique execution path through the action list that results in the initial state required for the particular simulation (or segment thereof). This may be achieved by adding an additional field to the action list that records if an action is waiting to be considered for execution, has been executed, or has been skipped.

At S801, the resource manager may initiate execution of a simulation segment 51, which may send the action list that describes the execution process to the relevant segment execution module 52 with fields identifying the path that resulted in the segment's initial state. The resource manager 51 starts execution (simulation) of a new segment every time it receives an action list (that is, the resource manager 51 may control multiple simulation ensembles or parts thereof at the same time or sequentially). Thus, the segment execution module 52 receives the action list from the resource manager 51 at S802.

At S803, the segment execution module 52 reads the state 53 from the state store 54 (where the correct state may be identified using the techniques as described above). The segment execution module 52 marks the first unexecuted or un-skipped action as executed at S804.

If this action is recorded as "null" (S805, "yes"), then the segment execution module 52 marks the action as skipped at S806 and, at S807, sends the updated action list (with the following, second, action marked as skipped) to the resource manager 51 (which may then initiate another segment execution - this is the bifurcation process, as previously mentioned). The segment execution module 52 then proceeds to execute the simulation at S809, advancing the state of the system by a time increment.

If the current action is not null (S805, "no"), at S808, the segment execution module 52 marks all actions in the action list that share a same identifier, denoting these are to be skipped.

The segment execution module 52 applies the action to modify the initial state with the action's effects and proceeds, at S809, to execute the simulation code to progress the simulation. This is repeated until the simulation time of the next un-skipped action in the action list is to be executed (that is, the first action not marked as executed or skipped; S810, "yes").

The segment execution module 52 saves the final state (this corresponds, for example, to a preliminary simulated segment state or an action simulated state) to the state store 54 at S811, where the state is identified in the manner described above.

The segment execution module 52 sends the updated action list to the resource manager 51 at S812, which may then cause execution of the next segment. In this manner, all relevant segments for the simulation are processed. Further, in this manner, the resource manager 51 is able to treat the simulation of the segment as an individual simulation, without need to keep track on all states of the simulations (and segments thereof) within an ensemble. The transmission of the updated action list is dependent, of course, on the environment in use, the file transfer protocols in use, and the inter-process communication protocol in use, etc. The process terminates at S813.

In the segment execution process, at each simulation time that an action could be applied, the simulation state should be made available to execution threads - preferably in a read-only manner. One way to do this that is suitable for implementation is to write the state to a file. The operating system may create a new process )i.e., the processing of the "other" branch of a simulation bifurcation) using the written file to create its initial state.

Alternatively, bifurcated execution threads may execute within the same process family (i.e., one bifurcated execution thread may have visibility to another bifurcated execution thread's state). In these systems, it is possible to "snapshot" a state and preserve it while the execution continues. In this case, execution of a single thread may continue to conclusion and the next execution thread may be chosen according to an appropriate search process. For instance, with reference to FIGURE 4, the branch for M₁₁ may be executed until completion, and then M₁₂, M₂₁, and finally M₂₂.

One appropriate search process includes finding the most recently saved state and executing the alternative path of the bifurcation to completion. By executing single threads to completion, this process minimises the storage required for recording states.

Alternatively, execution may proceed from the oldest recorded state (i.e., breadth first rather than depth first), for example after having deleted that state. For instance, again with reference to FIGURE 4, all simulation segments up to t₁₁ may be executed, followed by all up to t₂₁, etc. This requires a greater number of states to be saved but allows for pruning through comparison of saved states. Compute resource usage may then be reduced by saving segment states and reusing the states over simulation iterations where the previous action sequences are the same (or substantially the same).

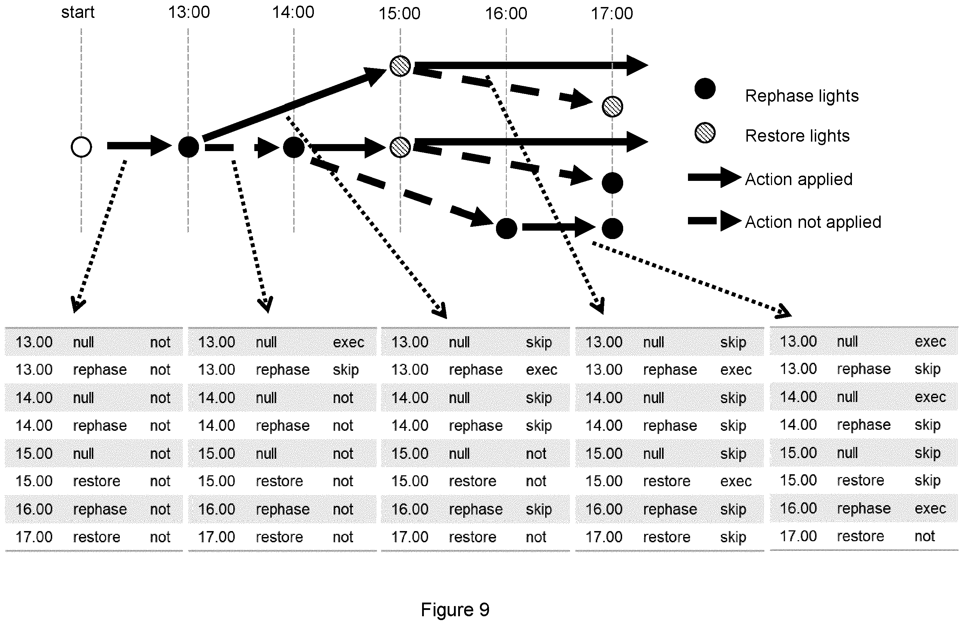

FIGURE 9 visualises the execution plan for a simulation of the options for traffic management described previously, together with extracts from the action list at selected times throughout the simulation. Each action list may be used in the above-described manner as an input to the start of the subsequent simulation segment. The options undergoing consideration result in 5 resultant states and the options explore the state evolution over 5 hours of real time. Using conventional techniques, the simulation would have had to simulate 5×5 hours. With the present techniques, the time is reduced to 16 hours, representing a cost saving of 36%.

Some actions may not have a significant effect on the underlying simulation. Similarly, the specific time at which an action is applied may not have a signification effect on the underlying simulation. If such a scenario is detected then it is possible to avoid execution of simulation branches of the overall simulation as the results from either execution path will be the same or sufficiently similar to warrant termination of one branch. That is, some proposed actions could have a negligible effect on the system under control, such that the states of the bifurcated threads remain very similar to each other. It may therefore be possible to prune an execution branch to reduce resource consumption by comparing states of the two threads (or aggregated statistics on the states) when a suitable state dump occurs during the application of another action. If they are sufficiently similar, the method may then include dropping execution of the state where the ineffectual action has been applied.

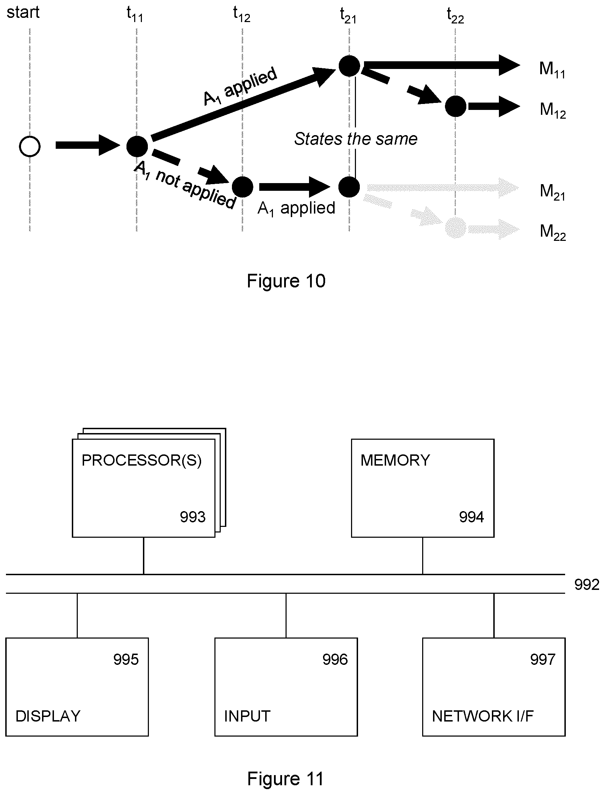

FIGURE 10 shows this concept, where the variation due to different application time of action A₁ is deemed to be negligible. In this instance, the effect of A₁ is assessed by comparing the two states recorded at t₂₁ following bifurcation of the simulation into two simulation branches (that is, comparing the state after A₁ is applied at t₁₁ and the state after A₁ is applied at t₁₂). The two states here are sufficiently similar, such that it is unnecessary to proceed with both bifurcated branches. The lower greyed-out branch is therefore not executed any further. Processing means may be used to instruct pruning or deletion of the relevant state 53 (or states) from the state store 55 as required, thereby improving memory usage.

Similarity of states may be determined using a threshold-based technique. For example, for a traffic simulation, one may compute the number of cars and the cars' average speed on each road segment; if the values he same (to within some tolerance), the states may be considered to be the same. Various measures of similarity may be suitably implemented, including Mahalanobis distance and Jaccard index, and - where data clustering is implemented - Euclidean distance.

FIGURE 11 is a block diagram of a computing device, such as a data processing server, which embodies the present invention, and which may be used to implement a method for traffic simulation. The computing device comprises a processor (or plurality thereof) 993 and memory, 994. Optionally, the computing device also includes a network interface 997 for communication with other computing devices, for example with other data storage devices or external data processing devices. An embodiment may be composed of a network of such computing devices.

Optionally, the computing device also includes one or more input mechanisms such as keyboard and mouse 996, and a display unit such as one or more monitors or screens 995. The components are connectable to one another via a bus 992.

The memory 994 may include a computer readable medium, a term which may refer to a single medium or multiple media (e.g., a centralised or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The processor 993 is configured to control the computing device and execute processing operations, for example executing code stored in the memory to implement the method for traffic simulation described here and in the claims. The memory 994 stores data being read and written by the processor 993. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an ASIC, a FPGA, a digital signal processor (DSP), network processor, or the like. In one or more embodiments, a processor is configured to execute instructions for performing the operations and steps discussed herein.

Display 995 may display a user interface. Input 996, in the form of a touchscreen or screen and keyboard and/or voice, may be used for user input. The user interface may be embodied as a user application shown on the display and optionally connected to the audio input/output of the user device for voice input and audio output. Local storage, for example of simulation parameters or of action lists or action plans, may be provided by memory 994, and processor 993 may carry out background functions. The core functionality (execution of simulation segments) may preferably be implemented remotely from the user device, for example on the cloud.

The network interface (network I/F) 997 may be connected to a network, such as the internet, and is connectable to other such computing devices via the network. The network I/F 997 may control data input/output from/to other apparatus via the network. Other peripheral devices such as microphone, speakers, etc. may be included in the computing device.

Resource manager 51 may be a processor 993 (or plurality thereof) executing instructions stored on a portion of the memory 994 and exchanging data via network I/F 997. In particular, processor 993 may execute processing instructions to determine the scope of the traffic simulation to be subject to an action and to allocate simulation segments to simulation segment execution modules as required.

A simulation segment execution module 52 may be a processor 993 (or plurality thereof) executing instructions stored on a portion of the memory 994 and exchanging data via network I/F 997. In particular, processor 993 may execute processing instructions to process traffic data from sensors and execute traffic simulations for relevant segments.

Processors 993 embodying resource manager 51 and simulation segment execution module 52 may execute instructions stored on a portion of the memory 994 to exchange data between modules via bus 992 to via network I/F 997 to external entities, such as traffic sensors.

Methods embodying the present invention may be carried out on a computing device such as that illustrated in FIGURE 11. Such a computing device need not have every component illustrated in FIGURE 11, and may be composed of a subset of those components. Methods embodying the present invention may be carried out by a single computing device in communication with one or more data storage servers via a network. The computing device may be a data storage itself storing preconfigured interventions, buffered sensor data, historical sensor data, multi-function optimisation models and parameters, etc.

A method embodying the present invention may be carried out by a plurality of computing devices operating in cooperation with one another. One or more of the plurality of computing devices may be a data storage server storing at least a portion of preconfigured interventions, buffered sensor data, historical sensor data, multi-function optimisation models and parameters, etc.

The various methods described above may be implemented by a computer program. The computer program may include computer code (e.g., instructions) arranged to instruct a computer to perform the functions of one or more of the various methods described above. For example, the steps of the methods described in relation to FIGURE 1 may be performed by the computer code. The steps of the methods described above may be performed in any suitable order. The computer program and/or the code for performing such methods may be provided to an apparatus, such as a computer, on one or more computer readable media or, more generally, a computer program product. The computer readable media may be transitory or non-transitory. The one or more computer readable media could be, for example, an electronic, magnetic, optical, electromagnetic, infrared, or semiconductor system, or a propagation medium for data transmission, for example for downloading the code over the Internet. Alternatively, the one or more computer readable media could take the form of one or more physical computer readable media such as semiconductor or solid state memory, magnetic tape, a removable computer diskette, a random access memory (RAM), a read-only memory (ROM), a rigid magnetic disc, and an optical disk, such as a CD-ROM, CD-R/W or DVD. The instructions may also reside, completely or at least partially, within the memory 994 and/or within controller circuitry of processor 993 during execution thereof by the computing system, the memory 993 and the controller circuitry of processor 993 also constituting computer-readable storage media.

In an implementation, the modules, components and other features described herein may be implemented as discrete components or integrated in the functionality of hardware components such as ASICS, FPGAs, DSPs or similar devices.

A "hardware component" is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may comprise a special-purpose processor, such as an FPGA or an ASIC. A hardware component may also include programmable logic or circuitry that is temporarily configured by software to perform certain operations.

In addition, the modules and components may be implemented as firmware or functional circuitry within hardware devices. Further, the modules and components may be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilizing terms such as "receiving", "determining", "comparing", "enabling", "maintaining", "identifying", "obtaining", "accessing", or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

While certain embodiments have been described, these embodiments have been presented by way of example only, and are not intended to limit the scope of the inventions. Indeed, the novel methods and apparatuses described herein may be embodied in a variety of other forms; furthermore, various omissions, substitutions and changes in the form of methods and apparatus described herein may be made.

## Claims

1. A computer-implemented method for traffic simulation, the method comprising:
accepting input of traffic data;
modelling the effects of an action in a traffic simulation at a plurality of possible time points, by:
executing a traffic simulation, using the traffic data, from an initial time point up to a first possible time point to obtain a first preliminary simulated segment state;
modifying the first preliminary simulated segment state with the action and executing the traffic simulation beyond a second possible time point to obtain an action simulated state for the first possible time point;
executing the traffic simulation from the first possible time point up to a second possible time point, using the first preliminary simulated segment state as an initial state, to obtain a second preliminary simulated segment state;
modifying the second preliminary simulated segment state with the action and executing the traffic simulation beyond the second possible time point to obtain an action simulated state for the second possible time point; and
comparing the simulated states, including the action simulated state for the first possible time point and the action simulated state for the second possible time point.

2. The method according to claim 1, comprising modelling the effects of a plurality of actions in a traffic simulation, by repeating the modelling for each action.

3. The method according to claim 2, further comprising:
modifying the action to obtain a modified action;
modifying the first preliminary simulated segment state with the modified action, and executing the traffic simulation beyond the second possible time point to obtain a modified action simulated state for the first possible time point;
modifying the second preliminary simulated segment state with the modified action and executing the traffic simulation beyond the second possible time point to obtain a modified action simulated state for the second possible time point; and
comparing the action simulated state for the first possible time point, the modified action simulated state for the first possible time point, the action simulated state for the second possible time point, and the modified action simulated state for the second possible time point.

4. The method according to claim 2 or claim 3, further comprising performing an optimisation search amongst the plurality of actions with respect to action parameters, to identify a selected action.

5. The method according to any preceding claim, wherein comparing the simulated states includes determination of a similarity metric between states and, when the similarity metric is above a threshold, deleting one of the action simulated state for the first possible time point and the action simulated state for the second possible time point.

6. The method according to any preceding claim, wherein modelling the effects of the action in the traffic simulation is triggered by receiving an action list, the action list comprising all actions to be applied to the traffic simulation and all possible time points at which the actions are to be applied to the traffic simulation.

7. The method according to any preceding claim, wherein
modelling the action in the traffic simulation further comprises saving simulated segment states to a state storage module, and
executing the traffic simulation is performed by a plurality of segment execution modules, the plurality of segment execution modules having access to the state storage module.

8. The method according to claim 7, wherein modelling the effects of the action in the traffic simulation further comprises scheduling executing the traffic simulation using a resource manager module.

9. The method according to any preceding claim preceding claim, wherein the traffic data is acquired in real-time from sensors.

10. The method according to claim 9, wherein the sensors are any or all of the following:
GPS sensors or antennas;
cellular network sensors or antennas;
loop sensors;
camera sensors; and
vehicle parking sensors.

11. The method according to any preceding claim, further comprising:
accepting input of historical traffic data; and
executing the traffic simulation using the traffic data and the historical traffic data.

12. The method according to any preceding claim, wherein the traffic data comprises data obtained from a digital twin of the geographic region.

13. A data processing apparatus comprising:
a memory storing computer-executable instructions to carry out the method of any of claims 1 to 12; and
a processor configured to execute the instructions.

14. A computer program comprising instructions that, when the program is executed by a computer, cause the computer to carry out the method of any of claims 1 to 12 .

15. A computer-readable medium comprising instructions that, when executed by a computer, cause the computer to carry out the method of any of claims 1 to 12.

## Amended claims

### Amended claims in accordance with Rule 137(2) EPC.

1. A computer-implemented method for traffic simulation, the method comprising:
accepting (S11) input of traffic data;
modelling (S12) the effects of an action in a traffic simulation at a plurality of possible time points, by:
executing (S121) a traffic simulation, using the traffic data, from an initial time point up to a first possible time point to obtain a first preliminary simulated segment state (20);
modifying (S122) the first preliminary simulated segment state (20) with the action and executing the traffic simulation beyond a second possible time point to obtain an action simulated state for the first possible time point (22);
executing (S123) the traffic simulation from the first possible time point up to a second possible time point, using the first preliminary simulated segment state (20) as an initial state, to obtain a second preliminary simulated segment state (23);
modifying (S124) the second preliminary simulated segment state (23) with the action and executing the traffic simulation beyond the second possible time point to obtain an action simulated state for the second possible time point (25); and
comparing (S125) the simulated states, including the action simulated state for the first possible time point (22) and the action simulated state for the second possible time point (25), wherein comparing the simulated states includes determination of a similarity metric between states and, when the similarity metric is above a threshold, deleting one of the action simulated state for the first possible time point (22) and the action simulated state for the second possible time point (25).

2. The method according to claim 1, comprising modelling the effects of a plurality of actions in a traffic simulation, by repeating the modelling for each action.

3. The method according to claim 2, further comprising:
modifying the action to obtain a modified action;
modifying the first preliminary simulated segment state (20) with the modified action, and executing the traffic simulation beyond the second possible time point to obtain a modified action simulated state for the first possible time point;
modifying the second preliminary simulated segment state (23) with the modified action and executing the traffic simulation beyond the second possible time point to obtain a modified action simulated state for the second possible time point; and
comparing the action simulated state for the first possible time point (22), the modified action simulated state for the first possible time point, the action simulated state for the second possible time point (25), and the modified action simulated state for the second possible time point.

4. The method according to claim 2 or claim 3, further comprising performing an optimisation search amongst the plurality of actions with respect to action parameters, to identify a selected action.

5. The method according to any preceding claim, wherein modelling (S12) the effects of the action in the traffic simulation is triggered by receiving an action list, the action list comprising all actions to be applied to the traffic simulation and all possible time points at which the actions are to be applied to the traffic simulation.

6. The method according to any preceding claim, wherein
modelling the action in the traffic simulation further comprises saving simulated segment states to a state storage module, and
executing the traffic simulation is performed by a plurality of segment execution modules, the plurality of segment execution modules having access to the state storage module.

7. The method according to claim 6, wherein modelling (S12) the effects of the action in the traffic simulation further comprises scheduling executing the traffic simulation using a resource manager module.

8. The method according to any preceding claim preceding claim, wherein the traffic data is acquired in real-time from sensors.

9. The method according to claim 8, wherein the sensors are any or all of the following:
GPS sensors or antennas;
cellular network sensors or antennas;
loop sensors;
camera sensors; and
vehicle parking sensors.

10. The method according to any preceding claim, further comprising:
accepting input of historical traffic data; and
executing the traffic simulation using the traffic data and the historical traffic data.

11. The method according to any preceding claim, wherein the traffic data comprises data obtained from a digital twin of the geographic region.

12. A data processing apparatus comprising:
a memory (994) storing computer-executable instructions to carry out the method of any of claims 1 to 11; and
a processor (993) configured to execute the instructions.

13. A computer program comprising instructions that, when the program is executed by a computer, cause the computer to carry out the method of any of claims 1 to 11.

14. A computer-readable medium comprising instructions that, when executed by a computer, cause the computer to carry out the method of any of claims 1 to 11.
